**Europäisches Patentamt**

**European Patent Office**

**Office européen des brevets**

(19)

(11) Veröffentlichungsnummer: **0 087 078**

**A2**

(12) # EUROPÄISCHE PATENTANMELDUNG

(21) Anmeldenummer: **83101293.5**

(22) Anmeldetag: **10.02.83**

(51) Int. Cl.³: **H 03 H 9/36**
**H 03 H 3/02**

(30) Priorität: **23.02.82 DE 3206452**

(43) Veröffentlichungstag der Anmeldung:
**31.08.83 Patentblatt 83/35**

(84) Benannte Vertragsstaaten:
**AT BE DE FR GB IT LU NL**

(71) Anmelder: **SIEMENS AKTIENGESELLSCHAFT**
**Berlin und München Wittelsbacherplatz 2**
**D-8000 München 2(DE)**

(72) Erfinder: **Diepers, Heinrich, Dr.**
**Veit-Stoss-Strasse 44**
**D-8552 Höchstadt(DE)**

(72) Erfinder: **Sachs, Bertram**
**Dorfstrasse 30**
**D-8520 Erlangen-Büchenbach(DE)**

(54) Ultraschall-Verzögerungsleitung und Verfahren zu seiner Herstellung.

(57) Die Ultraschall-Verzögerungsleitung (2) enthält piezo-elektrische Ultraschall-Scherwandler (10, 14), die auf einem flachen Profilkörper (4) aus einem Verzögerungsmedium angeordnet sind und deren Elektroden (11, 12) mit elektrischen Anschlußleitern (28 bis 31) versehen sind. Erfindungsgemäß sind die Oberflächenbereiche (20, 21) der Schmalseiten des Profilkörpers (4) zwischen benachbarten Metallisierungen (5, 6 bzw. 7, 8), die jeweils mit einer Elektrode (11, 12 bzw. 15, 16) des gleichen Ultraschall-Scherwandlers (10 bzw. 14) verbunden sind, sowie die diesem Oberflächenbereich (20 bzw. 21) zugewandte Stirnseite der Ultraschall-Scherwandler (10 bzw. 14) jeweils mit einer elektrisch isolierenden Abdeckung (23, 24) versehen, die als Unterlage für eine Kontaktbrücke (22, 26) vorgesehen ist. In dieser Ausführungsform kann die Kontaktierung der Ultraschall-Scherwandler (10, 14) auf den Metallisierungen (5 bis 8) des Profilkörpers (4) vorgenommen werden und die Ultraschall-Scherwandler (10, 14) werden somit nicht durch eine zusätz-liche Kontaktmasse ungünstig belastet.

EP 0 087 078 A2

SIEMENS AKTIENGESELLSCHAFT    Unser Zeichen
Berlin und München    VPA 82 P 3 0 4 8 E

Ultraschall-Verzögerungsleitung und Verfahren
zu seiner Herstellung

Die Erfindung bezieht sich auf eine Ultraschall-Verzögerungsleitung, insbesondere für Farbfernsehempfänger, mit piezoelektrischen Ultraschall-Scherwandlern, deren Elektroden jeweils mit einer Metallisierung der Schmalseiten eines flachen Profilkörpers aus einem Verzögerungsmedium verbunden sind und die mit elektrischen Anschlußleitern versehen sind.

Auf der Ultraschalltechnik aufbauende Verzögerungsleitungen bestehen bekanntlich im wesentlichen aus einem piezoelektrischen Ultraschall-Scherschwinger als Eingangswandler, der quer zur Richtung der anliegenden Signalspannung polarisiert ist, sowie einem Verzögerungsmedium und einem Ausgangswandler. Der Eingangswandler setzt ein zugeführtes elektrisches Signal in entsprechende mechanische Schwingungen um, die das Verzögerungsmedium, beispielsweise Glas, durchlaufen und deren Schallgeschwindigkeit in diesem Medium vermindert wird. Sie werden im Ausgangswandler wieder in elektrische Schwingungen zurücktransformiert. Durch die Gestaltung des Verzögerungsmediums als flacher Profilkörper, der zur Abdämpfung von Seitenkeulen auf seinen Flachseiten noch mit sogenannten Dämpferpunkten versehen sein kann, wird die Schallwelle mehrfach reflektiert und damit die Gesamtlänge der Verzögerungsleitung wesentlich vermindert. Die Ausdehnung des Profilkörpers wird vorzugsweise kleiner gewählt als die halbe Wellenlänge der Ultraschallschwingung. Mit solchen Verzögerungs-

Kin 2 Koe / 15.2.1982

leitungen erhält man eine große Störsignaldämpfung und zugleich nur eine geringe Betriebsdämpfung ("Funkschau" 1973, Heft 6, Seiten 1005 bis 1008).

Etwa die gleiche geringe Ausdehnung in Richtung der Dicke des Profilkörpers haben auch die Ultraschall-Scherschwinger, deren Elektroden jeweils mit einem elektrischen Anschlußleiter kontaktiert werden müssen. Da die Ultraschall-Verzögerungsleitung ein Präzisionsbauteil ist, das hohe geometrische Maßgenauigkeit erfordert und hohe Ansprüche an die Verarbeitungstechnologie stellt, können die üblichen Lotverbindungen nur mit einem verhältnismäßig großen Aufwand hergestellt werden.

Der Erfindung liegt die Aufgabe zugrunde, eine Ultraschall-Verzögerungsleitung anzugeben, die verhältnismäßig einfach hergestellt werden kann und bei der die Ultraschallwandler nicht durch eine zusätzliche Kontaktmasse ungünstig belastet werden.

Diese Aufgabe wird erfindungsgemäß gelöst mit den kennzeichnenden Merkmalen des Anspruchs 1. In einer besonders einfachen Ausführungsform der Ultraschall-Verzögerungsleitung kann die Oberfläche der Schmalseite des Profilkörpers zwischen der Metallisierung, die mit einer der Elektroden der Ultraschall-Scherwandler verbunden ist, und der benachbarten Metallisierung sowie die dieser Metallisierung zugewandte Stirnfläche der Ultraschall-Scherschwinger mit einem elektrisch isolierenden Kleber versehen werden, der beispielsweise aus einem selbsthärtenden Kunststoff, vorzugsweise einem Epoxidharz, bestehen kann. Ferner ist als Isolierstoff beispielsweise Siliziumdioxid $SiO_2$ oder auch Aluminiumoxid $Al_2O_3$ geeignet. Auf diese elektrisch isolierende Unterlage wird dann eine Kontaktbrücke zwischen der vom Profilkörper abgewandten Elektrode des Ultraschall-Scherschwingers und der benachbarten Metallisierung aufgebracht, vorzugsweise aufgesputtert.

In einer besonders vorteilhaften Ausführungsform der Ultraschall-Verzögerungsleitung wird die von dem Profilkörper abgewandte Elektrode der Ultraschall-Scherwandler und ihre Kontaktbrücke mit der zugehörigen Metallisierung in einem gemeinsamen Arbeitsgang hergestellt.

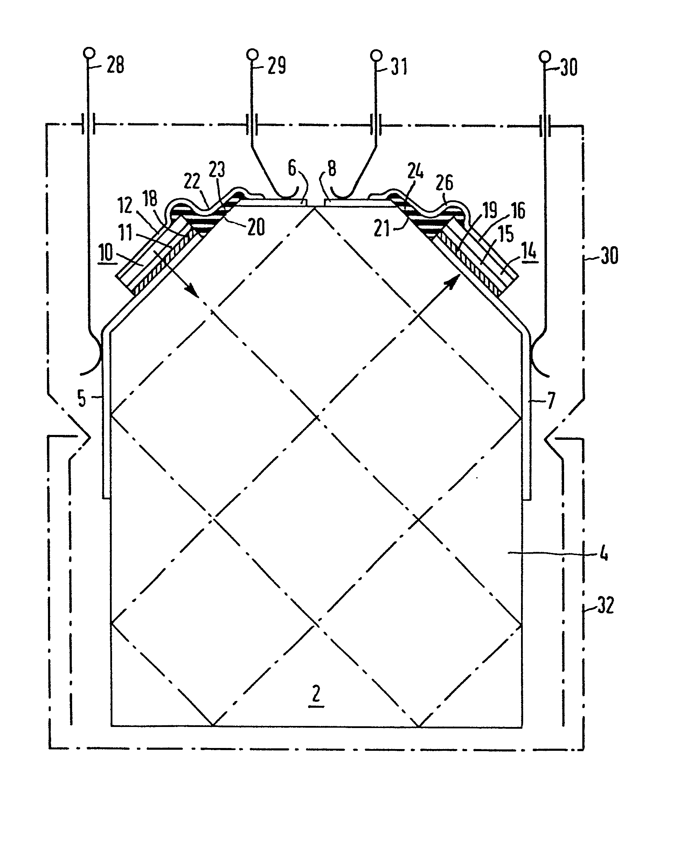

Zur weiteren Erläuterung der Erfindung wird auf die Zeichnung Bezug genommen, in der ein Ausführungsbeispiel einer Ultraschall-Verzögerungsleitung nach der Erfindung schematisch veranschaulicht ist.

Eine Ultraschall-Verzögerungsleitung 2, die beispielsweise für Farbfernsehempfänger nach dem PAL-System oder dem SECAM-System vorgesehen sein kann, enthält einen scheibenförmigen Profilkörper 4 aus einem Verzögerungsmedium, vorzugsweise Glas, der in vier verschiedenen Oberflächenbereichen seiner Schmalseiten mit Metallisierungen versehen ist, die in der Figur mit 5 bis 8 bezeichnet sind. Diese Metallisierungen können vorzugsweise jeweils aus mehreren Schichten verschiedener Metallkomponenten, beispielsweise Chrom, Kupfer, Gold oder Titan, Kupfer, Gold sowie Titan, Kupfer, Silber mit einer Gesamtdicke von vorzugsweise höchstens etwa 1 $\mu$m bestehen und in sogenannter Dünnschichttechnik hergestellt sein. Zwei Ultraschall-Scherwandler 10 und 14 sind an ihrer dem Profilkörper 4 zugewandten Oberfläche jeweils mit einer metallischen Elektrode 11 bzw. 15 versehen, die in gleicher Weise wie die Metallauflagen 5 bis 8 aufgebaut sein können. Der Ultraschall-Scherwandler 10 mit einem piezoelektrischen Schwingerkörper, der beispielsweise aus Blei-Zirkonat-Titanat PZT bestehen kann, ist mit seiner Metallauflage 11 mit Hilfe einer Lotschicht 18, die vorzugsweise aus mehreren Schichten verschiedener Metallkomponenten, insbesondere Indium-Zinn, bestehen kann, an der Metallauflage 5 des Profilkörpers 4 befestigt. Die Dicke der Lotschicht 18 ist abhängig von der Oberflächenrauhigkeit der Schmalseite des Profilkörpers 4 sowie von der Rauhigkeit der dem Profilkörper zugewandten Oberfläche der Ultraschall-Scherwandler 10 und 14 und beträgt im allgemeinen nicht wesentlich mehr als 10 $\mu$m. Die Lotschichten 18 und 19 können vorzugsweise ebenfalls in Dünnschichttechnik hergestellt sein und entweder auf die Metallauflagen 11 und 15 der Ultraschall-Scherwandler 10 bzw. 14 oder auch auf die Metallauflagen 5 bzw. 7 aufgebracht, vorzugsweise aufgedampft, sein. Die Lotverbindung kann vorzugsweise durch Wiederaufschmelzen der Metallkomponenten, insbesondere durch Vakuumlöten, hergestellt werden.

Die Oberflächenbereiche 20 und 21 der Schmalseite des Profilkörpers 4 zwischen den Metallauflagen 5 und 6 bzw. 7 und 8 werden jeweils mit einer elektrisch isolierenden Abdeckung 23 bzw. 24 abgedeckt, die aus einem elektrisch isolierenden Klebstoff, beispielsweise einem Kunststoffkleber auf der Basis von Epoxidharz oder einem beispielsweise mit Epoxidharz getränkten isolierenden Faden mit beispielsweise etwa 50 $\mu$m Durchmesser, bestehen kann. Vorzugsweise geeignet als Abdeckungen sind dünne Keramikschichten, beispielsweise aus Aluminiumoxid $Al_2O_3$, oder auch Schichten aus Siliziumoxid SiO oder $SiO_2$, deren Dicke vorzugsweise höchstens einige $\mu$m beträgt. Sie werden in der Weise abgeschieden, vorzugsweise aufgesputtert oder auch aufgedampft, daß sie sowohl den Oberflächenbereich 20 bzw. 21 zwischen den Metallauflagen 5 und 6 bzw. 7 und 8 als auch jeweils

die angrenzenden Stirnflächen der Ultraschall-Scherwandler 10 bzw. 14 bedecken und damit eine elektrische
Auftrennung zwischen den Elektroden der Ultraschall-
Scherwandler 10 und 14 bewirken, die vorzugsweise ebenfalls aus mehreren Metallkomponenten mit einer Gesamtdicke von höchstens etwa 1 /um bestehen und in Dünnschichttechnik hergestellt sein können. Diese Elektroden
12 und 16 werden dann mit Hilfe einer elektrisch
leitenden Kontaktbrücke 22 bzw. 26 mit der Metallauflage 6 bzw. 8 elektrisch leitend verbunden.

Eine besonders vorteilhafte weitere Ausgestaltung der
Ultraschall-Verzögerungsleitung 2 besteht darin, daß
die Elektroden 12 und 16 der Ultraschall-Scherwandler 10
bzw. 14 jeweils zusammen mit ihrer zugehörigen Kontaktbrücke 22 bzw. 26 ein gemeinsames Bauteil bilden und
vorteilhaft in einem gemeinsamen Arbeitsgang aufgebracht,
vorzugsweise aufgesputtert oder aufgedampft, sein
können. Eine zusätzliche Lotverbindung zwischen den
Elektroden 12 und 16 und der zugehörigen Kontaktbrücke
22 bzw. 26 ist somit nicht erforderlich und die Ultraschall-Scherwandler 10 und 14 können nicht durch zusätzliche Kontaktmassen belastet werden.

Die elektrische Kontaktierung der Ultraschall-Scherwandler 10 und 14 kann in dieser Ausführungsform der
Ultraschall-Verzögerungsleitung 2 jeweils an einer der
Metallisierungen 5 bis 8 des Profilkörpers 4 vorgenommen
werden. Zu diesem Zweck sind vorzugsweise Federkontakte
28 bis 31 geeignet, die eine elektrische Verbindung mit
einem in der Figur nicht dargestellten Anschlußleiter
lediglich durch einen Druckkontakt herstellen. Sie
können vorzugsweise jeweils in einem als Klemmhalterung
ausgebildeten Deckel 30 eines Gehäuses 32 mechanisch
fixiert sein, das in der Figur lediglich schematisch
strichpunktiert angedeutet ist.

Zum Herstellen der Ultraschall-Verzögerungsleitung 2 kann man vorteilhaft einen langgestreckten Profilkörper aus einem Verzögerungsmedium dadurch mit streifenförmigen Metallauflagen, aus denen die Metallauflagen 5 bis 8 entstehen sollen, versehen, daß die metallfreien Oberflächenbereiche 20 und 21 zwischen den Metallauflagen 5 und 6 bzw. 7 und 8 und auch zwischen den Metallauflagen 6 und 8 und unter Umständen auch die Oberflächenbereiche an den Seiten und der Bodenfläche des Profilkörpers 4 in bekannter Weise abgedeckt werden. Anschließend werden die streifenförmigen Metallauflagen, von denen in der Figur nur die Stirnflächen sichtbar sind, durch Aufbringen, vorzugsweise durch Aufsputtern, mehrerer Metallkomponenten in Dünnschichttechnik hergestellt.

Es kann aber auch zunächst eine gemeinsame Metallauflage aufgebracht werden, aus der dann die metallfreien Oberflächenbereiche zwischen den Metallauflagen durch Abtragen des Metalls, beispielsweise durch Abschleifen, wieder freigelegt werden. Die Herstellung der unlösbaren Verbindung zwischen den Ultraschall-Scherschwingern 10 und 12 erfolgt durch Erwärmung bis oberhalb der eutektischen Temperatur der verwendeten Metallkomponenten, vorzugsweise im Vakuum. Nach dem Herstellen der Verbindung der Ultraschall-Scherschwinger 10 und 24 und der Kontaktbrücken 22 und 26 werden die einzelnen Ultraschall-Verzögerungsleitungen 2 durch Auftrennen des langgestreckten Profilkörpers hergestellt.

Im Ausführungsbeispiel ist die Anwendung der Ultraschall-Verzögerungsleitung für Farbfernseher angegeben. Diese Verzögerungsleitungen können jedoch auch auf anderen technischen Gebieten verwendet werden, beispielsweise für Videorecorder oder auch in der Radartechnik.

4 Patentansprüche
1 Figur

Patentansprüche

1. Ultraschall-Verzögerungsleitung (2), insbesondere für Farbfernsehempfänger, mit piezoelektrischen Ultraschall-Scherwandlern (10, 14), deren Elektroden (11, 12; 15, 16) jeweils mit einer Metallauflage (5 bis 8) der Schmalseiten eines flachen Profilkörpers (4) aus einem Verzögerungsmedium verbunden und elektrisch kontaktiert sind, d a d u r c h  g e k e n n z e i c h n e t , daß die Oberflächenbereiche (20, 21) der Schmalseiten des Profilkörpers (4) zwischen benachbarten Metallauflagen (5, 6 bzw. 7, 8), die jeweils mit einer Elektrode (11, 12; 15, 16) desselben Ultraschall-Scherwandlers (10 bzw. 14) verbunden sind sowie die diesem Oberflächenbereich (20, 21) zugewandte Stirnseite der Ultraschall-Scherwandler (10 bzw. 14) jeweils mit einer elektrisch isolierenden Abdeckung (23, 24) versehen sind, die jeweils als Unterlage für eine Kontaktbrücke (22 bzw. 26) vorgesehen sind.

2. Ultraschall-Verzögerungsleitung nach Anspruch 1, d a d u r c h  g e k e n n z e i c h n e t ,  daß die Kontaktbrücken (22, 26) mit den angeschlossenen Elektroden (12 bzw. 16) jeweils ein gemeinsames Bauteil bilden.

3. Ultraschall-Verzögerungsleitung nach Anspruch 1 oder 2, d a d u r c h  g e k e n n z e i c h n e t ,  daß die Metallauflagen (5 bis 8) jeweils mit einem Federkontakt (28 bzw. 29 bzw. 30 bzw. 31) versehen sind.

4. Verfahren zum Herstellen einer Ultraschall-Verzögerungsleitung nach einem der Ansprüche 1 bis 3, d a d u r c h  g e k e n n z e i c h n e t ,  daß die Kontaktbrücken (22, 26) mit den anzuschließenden Elektroden (12 bzw. 16) der Ultraschall-Scherwandler (10, 14) in einem gemeinsamen Arbeitsgang aufgebracht werden.

0087078

82 P 3048